# EUROPÄISCHE PATENTSCHRIFT

(11) **EP 0 419 691 B1**
(45) Veröffentlichungstag und Bekanntmachung des Hinweises auf die Patenterteilung: **01.06.1994**
(21) Anmeldenummer: 89117656.2
(22) Anmeldetag: 25.09.1989
(51) Int. Cl.: H05K 7/14

(54) **Aus einzelnen Baugruppen zusammengesetzte elektrische Anlage**
Electrical installation consisting of assembled single modules
Installation électrique formée par un assemblage de modules séparés

(43) Veröffentlichungstag der Anmeldung: 03.04.1991
(73) Patentinhaber: SIEMENS AKTIENGESELLSCHAFT, 80333 München (DE)
(72) Erfinder: Meusel, Otto, D-8520 Erlangen (DE); Burger, Josef, Dipl.-Ing. FH, D-8477 Schmidgaden (DE); Deinhardt, Günther, Dipl.-Ing. FH, D-8450 Amberg (DE); Schirbl, Reinhard, D-8460 Schwandorf (DE)

(56) Entgegenhaltungen:
- EP-A- 0 181 492
- DE-U- 8 415 458
- IBM TECHNICAL DISCLOSURE BULLETIN, Bd. 26, Nr. 3b, August 83, New York,US;Seiten 1468 - 1469; B. SASSEN: "Connector alignment block"

## Beschreibung

Die Erfindung bezieht sich auf eine elektrische Anlage, zusammengesetzt aus einzelnen Baugruppen und mit einem Baugruppenträger, der eine Busleiterplatte aufweist, an der Steckanschlüsse befestigt sind, die mit Gegensteckanschlüssen der Baugruppen durch Aufschwenken elektrisch in Verbindung bringbar und worauf die Baugruppen mechanisch am Baugruppenträger gehalten sind.

Bei einer bekannten Anlage der obengenannten Art (DE-U-84 15 458) besteht der Baugruppenträger aus einer metallenen Profilplatte, die eine Einschwenkhalterung für die Baugruppen aufweist. Die Steckanschlüsse, die mit den Gegensteckanschlüssen der Baugruppen in ihrem eingeschwenkten Zustand in Verbindung stehen, sind über die Busleiterplatte mit der Profilplatte verbunden. Die Lagegenauigkeit der Steckanschlüsse und der Gegensteckanschlüsse zueinander ist jedoch hierbei durch die Toleranzkette von Steckanschlußbefestigung, Busleiterplatte, Profilplatte, Einschwenkhalterung der Baugruppen und der Befestigung der Gegensteckanschlüsse bestimmt.

Der Erfindung liegt die Aufgabe zugrunde, diese bekannte Anordnung hinsichtlich der für die Kontaktverbindung erforderlichen Lagegenauigkeit von Steck- und Gegensteckanschlüssen zueinander zu verbessern.

Diese Aufgabe wird bei einer Anordnung der obengenannten Art dadurch gelöst, daß
1. zum Baugruppenträger ein Kunststoffträger gehört,
2. der Kunststoffträger mindestens eine zur Aufnahme der Steckanschlüsse dienende Öffnung aufweist,
3. am Kunststoffträger in definiertem Abstand zur Öffnung mindestens ein erster Vorsprung vorgesehen ist,
4. die Busleiterplatte in definiertem Abstand zu den Steckanschlüssen mindestens zwei Positionieröffnungen aufweist,
5. an der den Baugruppen abgewandten Seite des Kunststoffträgers mindestens zwei den Positionieröffnungen in Lage und Form angepaßte zweite Vorsprünge vorgesehen sind,
6. für die zweiten Vorsprünge und Positionieröffnungen eine solche Lage vorgesehen ist, daß in deren zusammengefügtem Zustand die Steckanschlüsse in definiertem Abstand zum ersten Vorsprung liegend in die Öffnungen hineinragen und von der den Baugruppen zugewandten Seite des Kunststoffträgers her mit den Gegensteckanschlüssen kontaktierbar sind, wozu die Baugruppen über ein Abstützteil an dem ersten Vorsprung abstützbar sind, das in einem Abstand zu den Gegensteckanschlüssen vorgesehen ist, der mit dem zwischen dem Vorsprung und den Steckanschlüssen am Baugruppenträger abgestimmt ist.
Der beschriebene Baugruppenträger zeichnet sich durch seinen sandwichartigen Aufbau aus. Die verschiedenen Komponenten des Baugruppenträgers wie z.B. die Busleiterplatten und der Kunststoffträger weisen obengenannte Positioniermittel auf, die das Aufeinanderschichten in vorbestimmter Weise leicht ermöglichen und auch eine automatengerechte Fertigung zulassen. Selbstverständlich können die als Positioniermittel dienenden Öffnungen und Vorsprünge sowie das Abstützteil vertauscht angeordnet werden.

Besitzen die Baugruppen auf der Seite der Gegensteckanschlüsse ein Kunststoffteil mit dem Abstützteil, und sind die Gegensteckanschlüsse an einer Leiterplatte befestigt, die erste Löcher aufweist, in welche Zapfen des Kunststoffteils eingreifen, so läßt sich hiermit die Lagegenauigkeit der Gegensteckanschlüsse zu dem als Positioniermittel dienenden Abstützteil erreichen, wobei dieser Aufbau eine Fertigung mittels eines Automaten ermöglicht. Ist der erste Vorsprung ein Federteil, so lassen sich hiermit noch weiterhin bestehende Toleranzen, aufgrund des Zusammenwirkens der verschiedenen Komponenten von Baugruppen und Baugruppenträger, ausgleichen, was das Zusammenfügen der Steck- und Gegensteckanschlüsse erleichtert.

Ist das Federteil in einem solchen Abstand von den Steckanschlüssen angeordnet, daß die Baugruppe beim Aufschwenken über ihr Abstützteil soweit von dem Federteil hinabgedrückt wird, daß die Oberkante des Gehäuses der Gegensteckanschlüsse unterhalb der Oberkante des Gehäuses der Steckanschlüsse zu liegen kommt, so lassen sich durch den Federweg des Federteils nach oben die Steck- und Gegensteckanschlüsse in gegenüberliegende Position bringen und dann einfach, genau und sicher zusammenfügen. Die Steckanschlüsse sind üblicherweise an ihren Schmalseiten angeschrägt, so daß die Gegensteckanschlüsse auf die Steckanschlüsse leicht aufgleiten. Dadurch, daß die Steckanschlüsse als Federleisten und die Gegensteckanschlüsse als Messerleisten ausgeführt sind, ist eine Vielzahl von Anschlußverbindungen auf engem Raum möglich. Besitzt der Kunststoffträger eine modulare Aufteilung in mehrere Moduleinbauplätze, wobei jedem Moduleinbauplatz mindestens eine Öffnung zugeordnet ist, so läßt sich hiermit eine flexible, d.h. den technischen Anforderungen angepaßte elektrische Anlage erstellen. Z.B. kann bei dem nach Norm 19 Zoll breiten Baugruppenträger über 18 Moduleinbauplätze verfügt werden. Weist jeder Moduleinbauplatz an seinem Rand einen ersten Absatz mit einer zur Baugruppe vorgesehenen Formpassung auf, die zumindest stellenweise ein Anliegen der Baugruppe an dem ersten Absatz beim Einschwenken und im eingeschwenkten Zustand der Baugruppe bewirkt, so wird durch die hiermit gegebene seitliche Führung das Einschwenken der Baugruppe und damit auch die Verbindung der Steck- und Gegensteckanschlüsse erleichtert und die seitliche Halterung der Baugruppe im eingeschwenkten Zustand verbessert. Indem Baugruppen mit mehrfacher Breite eines Moduleinbauplatzes vorgesehen sind, die an den ersten Absätzen mehrerer Moduleinbauplätze stellenweise anliegen, können die Leiterplatten der Baugruppen auch mit Komponenten größerer Abmessungen bestückt oder pro Baugruppe mehr als eine Leiterplatte vorgesehen werden. Weiterhin wird die Halterung solcher Baugruppen durch die ersten Absätze ebenfalls gefestigt, was insbesondere die Seitenstabilität betrifft. Ist das Kunststoffteil der Baugruppen mindestens teilweise um die Messerleisten herum als vorstehende Schürze ausgebildet, so sind hiermit die Gegenstecksteckanschlüsse gegen Verformung in einfacher Weise geschützt. Die vorstehende Schürze ist in ihren Abmessungen dem ersten Absatz angepaßt, so daß sie durch diesen beim Aufschwenken geführt wird. Doppelt und mehrfach breite Baugruppen weisen eine entsprechend breite Schürze auf, die mehrere erste Absätze beim Aufschwenken umgreift. Dadurch, daß der Baugruppenträger mehr als eine Busleiterplatte aufweist, kann die elektrische Anlage, den Anforderungen angepaßt, mit einer oder mehreren Busleiterplatten aufgebaut und betrieben werden, wodurch eine entsprechende wirtschaftliche Anpassung möglich ist. Indem eine zur Baugruppenbefestigung dienende Einschwenkhalterung am Kunststoffträger vorgesehen ist, läßt sich die Einschwenkhalterung nicht nur in einfacher Weise fertigen, sondern sie kann auch als ein die Verbesserung der Lagegenauigkeit der Steckanschlüsse unterstützendes Mittel wirken. Durch die am Kunststoffträger vorgesehene Einschwenkhalterung wird eine von den Maßtoleranzen der als rückwärtiger, stabilisierender Träger dienenden Profilplatte unabhängige Befestigung und Halterung der Baugruppe erreicht. Ist zwischen dem Kunststoffträger und dem Baugruppenträger mindestens eine Masseschiene vorgesehen, die über mindestens einen Durchbruch in dem Kunststoffträger des Moduleinbauplatzes kontaktierbar ist, so ist hierüber der Masseanschluß der Leiterplatte in der Baugruppe auf kurzem Wege in einfacher Weise möglich. Besitzt die Masseschiene vorstehende, leitende Kontaktteile, die durch die Durchbrüche zur Anschlußseite des Baugruppenträgers hin vorragen, so kann die Kontaktierung der Kontaktteile mit entsprechend an der Baugruppe angeordneten Gegenkontakten erfolgen, die an der Baugruppe eng anliegend und damit gegenüber mechanischer Beanspruchung geschützt angeordnet werden können. Eine kostengünstige, einfache Fertigung der Masseschiene mit den Kontaktteilen läßt sich erreichen, wenn die Kontaktteile abgewinkelte, z.B. umgebogene Teile der Masseschiene sind. Sind die Kontaktteile mit der Masseschiene elektrisch leitend verbindbar, so ist auch die Verwendung von Kontaktteilen komplizierter Bauform möglich, die für sich einfacher und kostengünstiger in Anpassung an die erforderliche Raumform hergestellt werden können als in einer durch die Masseschiene gegebenen Einheit. Es erweist sich als vorteilhaft, wenn die Kontaktteile Metallzungenpaare sind, die als Schenkel von L-förmigen Teilen ausgebildet sind, da sich diese mit geringem Aufwand fertigen und am Kunststoffträger einfach montieren lassen. Ist der Baugruppenträger aus dem Kunststoffträger, einem parallel angeordneten Träger und der zwischen diesem und dem Kunststoffträger liegenden Busleiterplatte zusammengesetzt, und besitzen diese Bauteile Mittel zur Positionierung beim Aufeinanderschichten, so stellt dies eine für die Fertigung günstige Sandwichbauweise dar, wobei der elektrische und mechanische Aufbau des Baugruppenträgers nicht beeinträchtigt ist. Eine günstige Ausgestaltung besteht darin, daß durch den Kunststoffträger, den Baugruppenträger und durch die Masseschiene in einer Flucht ein zweites Loch hindurchführt und in dieses zweite Loch eine metallische Gewindebuchse vom Kunststoffträger her steckbar ist, die ein durchgehendes Gewinde aufweist und die über dieses Gewinde die Masseschiene und die Kontaktteile mittels einer Schraube von der Rückseite des Baugruppenträgers her gegen den Träger drückt. Der Kunststoffträger, die Masseschiene und der Baugruppenträger werden durch die in dem zweiten Loch steckende Gewindebuchse auf einfache Weise zusammengehalten. Die Gewindebuchse kann unverdrehbar in den Kunststoffträger eingebracht werden, wenn die Gewindebuchse einen sechskantigen Kopf aufweist und der Kunststoffträger mit einer Ausnehmung in Form des sechskantigen Kopfes am Eingang des zweiten Loches versehen ist. Es erweist sich außerdem als vorteilhaft, wenn der Kunststoffträger einen Hohlraum zur Busleiterplatte hin aufweist, weil in diesem Hohlraum Bauelemente untergebracht werden können, die beispielsweise direkt auf der Busleiterplatte angeschlossen sind.

Weist wenigstens ein Moduleinbauplatz des Baugruppenträgers ein Codierelement auf, so ist hieran nur eine angepaßt codierte Baugruppe anschließbar, womit der unter Umständen zu Schäden oder Fehlfunktionen führende Anschluß einer nicht passenden Baugruppe vermieden wird. Ist zur Aufnahme des Codierelements eine zweite Ausnehmung am Kunststoffträger vorgesehen und ist am Boden der zweiten Ausnehmung ein Federelement vorhanden, so läßt sich das Codierelement versenkt in der zweiten Ausnehmung einfügen, wobei das Federelement das an sich zum Ausgleich von Toleranzen bewegliche Codierelement in eine definierte Position drückt.

In der Zeichnung ist ein Ausführungsbeispiel der Erfindung dargestellt, das im folgenden näher beschrieben ist.

Es zeigen in perspektivischer Darstellung:
- FIG 1: einen Baugruppenträger mit einer aufgeschwenkten Baugruppe sowie einem Kunststoffträger mit mehreren Moduleinbauplätzen,
- FIG 2: die Rückseite des Kunststoffträgers,
- FIG 3: eine weitere Ausführungsform eines Baugruppenträgers
- FIG 4: eine erste Baugruppe mit ihrer die Gegensteckanschlüsse aufweisenden Seite,
- FIG 5: eine U-förmige Feder und ein hierzu gehöriges Metallzungenpaar,
- FIG 6: eine weitere Ausführungsform der Baugruppe mit ihrer die Gegensteckanschlüsse aufweisenden Seite,
- FIG 7: eine Leiterplatte mit Schirmung,
- FIG 8: einen Teilschnitt durch den Baugruppenträger.

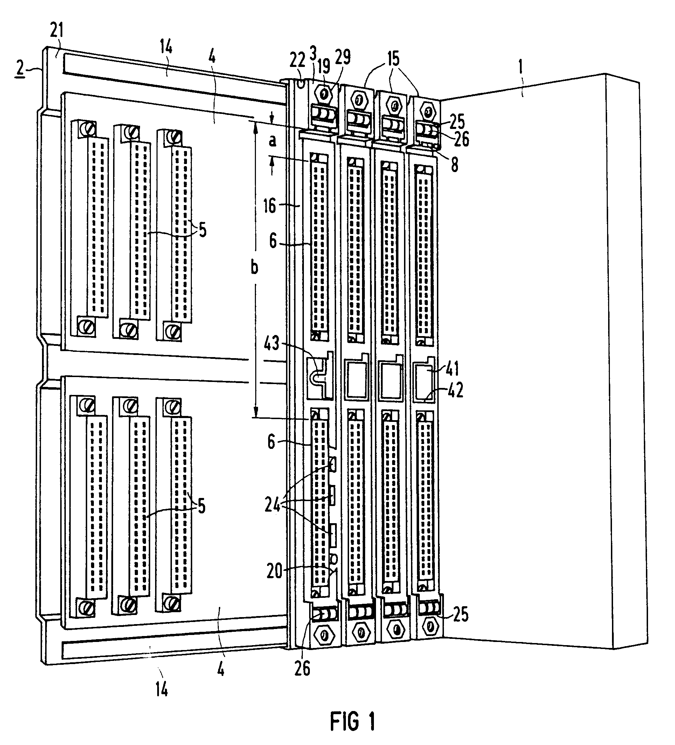

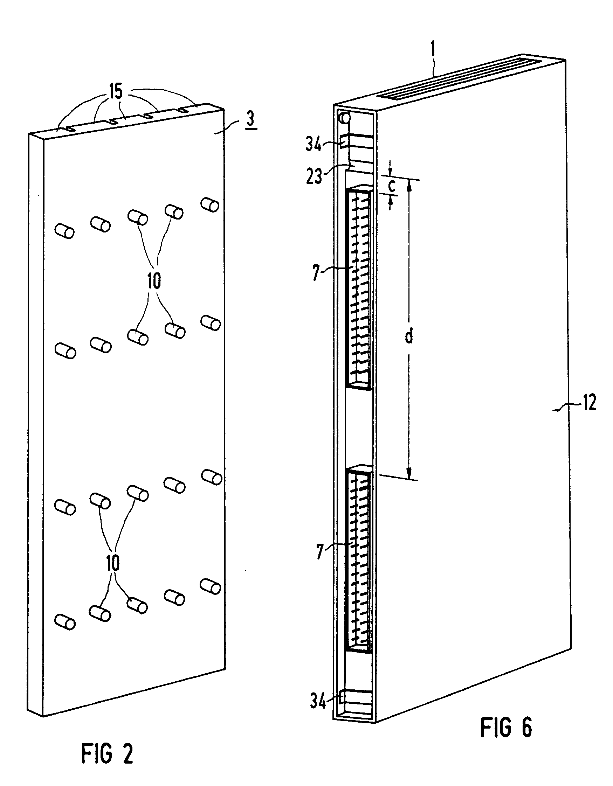

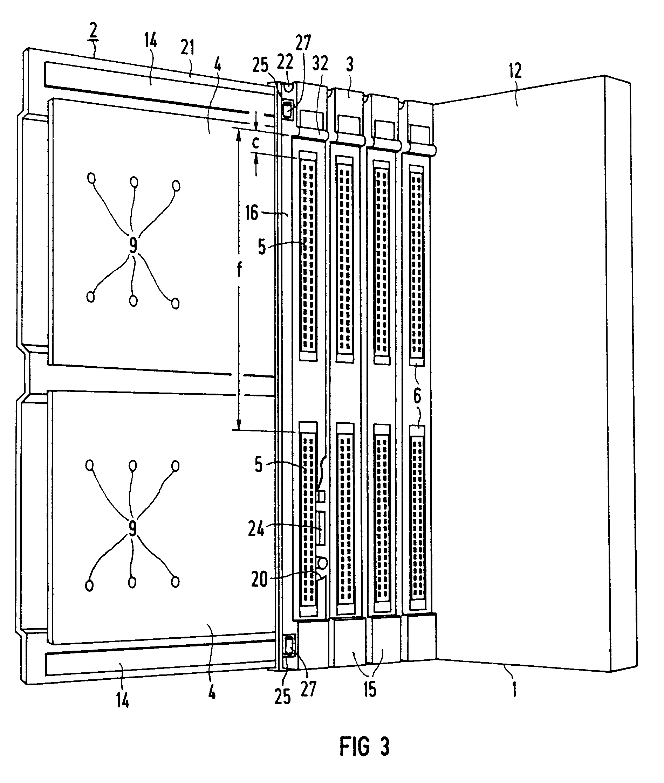

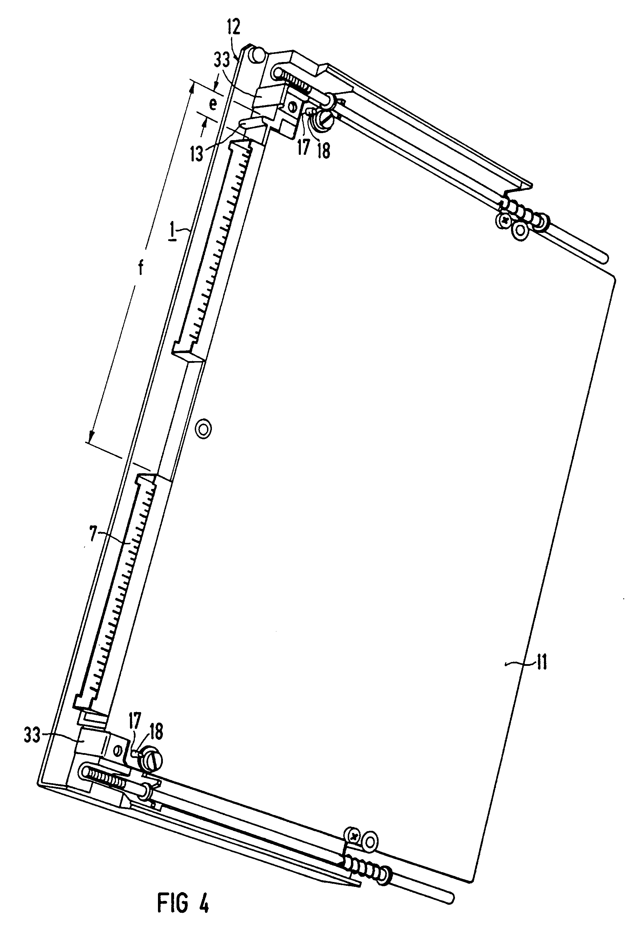

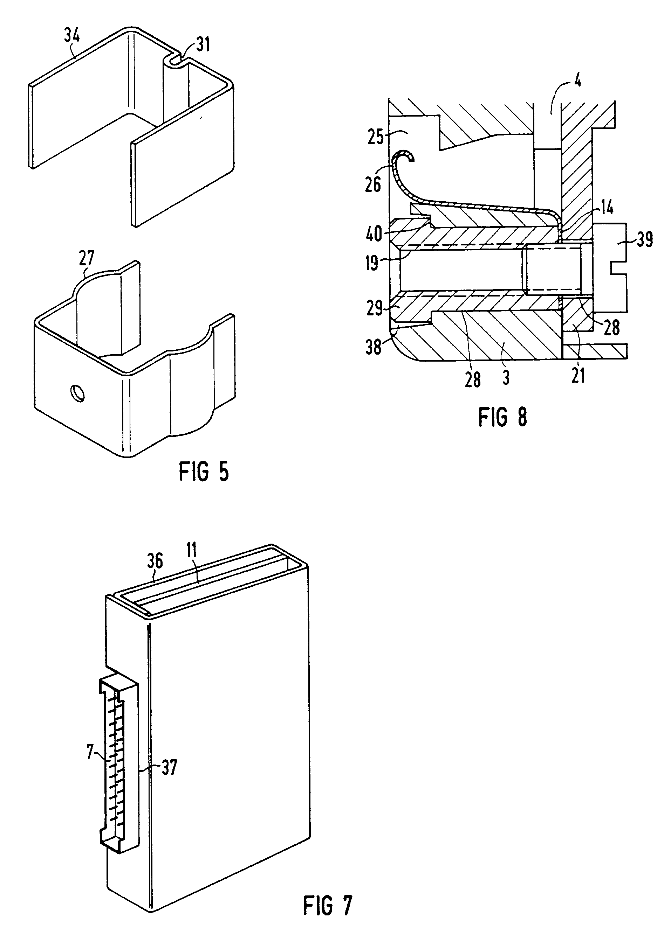

Aus FIG 1 ist ein Baugruppenträger 2, bestehend aus einem Aluminiumträger 21, aus zwei Busleiterplatten 4 und einem Kunststoffträger 3 ersichtlich, an dem eine Baugruppe 1 gehaltert ist. Die Busleiterplatte 4 mit den an ihr lagegenau positionierten und befestigten Steckanschlüssen 5 ist auf dem Aluminiumträger 21 angebracht. Als Steckanschlüsse sind hier Federleisten 5 verwendet, die eine Vielzahl von Kontaktverbindungen auf engem Raum ermöglichen. Der Kunststoffträger 3, der eine modulare Aufteilung in mehrere Moduleinbauplätze 15 besitzt, ist auf den Aluminiumträger 21 geschraubt. Jedem Moduleinbauplatz 15 sind zwei rechteckförmige Öffnungen 6 zugeordnet, deren Größe und Lage den Abmessungen und der Lage der Federleisten 5 zu deren Aufnahme angepaßt ist. Bei der Befestigung des Kunststoffträgers 3 wird dieser mittels seiner stiftförmigen Vorsprünge 10 (siehe FIG 2) auf der den Baugruppen 1 abgewandten Seite zu den Busleiterplatten 4 über deren Positionieröffnungen 9 (siehe FIG 3) derart positioniert, daß die Federleisten 5 in die Öffnungen 6 hineinragen. Somit ist die Verbindung der Federleisten 5 mit als Messerleisten 7 (siehe FIG 4) ausgeführten Gegensteckanschlüssen der Baugruppen 1 möglich. Jedem Moduleinbauplatz 15 ist eine Einschwenkhalterung 22 am Kunststoffträger 3 zugeordnet, in deren Nahe ein als Federteil 8 ausgeführter Vorsprung liegt. Die Ausführung mit einem Federteil 8 als Vorsprung erweist sich insbesondere zum Ausgleich der Herstelltoleranzen als günstig. Zwischen dem als Positioniermittel verwendeten Federteil 8 und den Federleisten 5 bestehen im zusammengebauten Zustand des Baugruppenträgers 2 bestimmte Abstände a, b. Parallel zu den außenliegenden Längsseiten der beiden Busleiterplatten 4 verlaufen zwischen dem Kunststoffträger 3 und dem Aluminiumträger 21 Masseschienen 14 zum Anschluß von M-extern für die Schirmung und zum Schutzleiteranschluß. Die Masseschienen 14 haben die Form von leitfähigen Bändern oder Schienen, die auf den Aluminiumträger 21 aufgebracht werden, können aber auch durch den Aluminiumträger 21 selbst gebildet werden. Der Rand jedes Moduleinbauplatzes 15 ist mit einem Absatz 16 versehen. Der Absatz 16 besitzt zur Busleiterplatte 4 hin einen Hohlraum 20, in dem z.B. Bauelemente 24 Platz finden, die an der Busleiterplatte 4 elektrisch angeschlossen werden können. Auf diese Weise sind die Bauelemente 24 durch den Absatz 16 gegen äußere mechanische Einwirkungen geschützt. Im Kunststoffträger 3 des Moduleinbauplatzes 15 sind im Bereich der Masseschienen 14 Durchbrüche 25 vorgesehen, durch die Kontaktteile 26 in Form von Fingern zur Anschlußseite des Baugruppenträgers 2 hindurchragen. Die Kontaktteile 26 gehören hier zu den Masseschienen 14 als abgebogene, gekrümmte Finger. Durch den Kunststoffträger 3, den Aluminiumträger 21 und durch die Masseschiene 14 führt in einer Flucht ein Loch 28 hindurch, in das eine mit einem Absatz und einem durchgehenden Innengewinde 19 versehene Gewindebuchse 29 mit sechskantigem Kopf vom Kunststoffträger 3 her steckbar ist (siehe FIG 8). Die Gewindebuchse 29 weist nach FIG 8 zwischen ihrem Schaft und dem sechskantigen Kopf einen Absatz 40 auf und besitzt am Schaftende eine ebene Fläche. Der Schaft ist in seinem Durchmesser dem des Loches 28 angepaßt. Die Gewindebuchse 29 liegt mit ihrem sechskantigen Kopf in einer entsprechend ausgebildeten Ausnehmung 38 im Kunststoffträger 3 am Eingang des Loches 28, wodurch sie unverdrehbar ist. Die ebene Fläche der Gewindebuchse 29 am Schaftende liegt auf der zwischen dem Kunststoffträger 3 und dem Aluminiumträger 21 liegenden Masseschiene 14 mit den Kontaktteilen 26 auf und drückt die Masseschiene 14 beim Festdrehen der Gewindebuchse 29 durch eine an der Rückseite des Aluminiumträgers 21 in das Gewinde eingeführte Schraube 39 gegen den Aluminiumträger 21. Über den Absatz 40 wird dabei auch der Kunststoffträger 3 mit dem Aluminiumträger 21 und den Busleiterplatten 4 zusammengehalten.

FIG 1 zeigt außerdem an jedem Moduleinbauplatz 15 im Mittelbereich des Kunststoffträgers 3 eine Ausnehmung 42, die zur Aufnahme eines Codierelements 41 dient. Nur diesem jeweiligen Codierelement 41 entsprechend angepaßt codierte Baugruppen 1 sind somit auf die Moduleinbauplätze 15 steckbar, wodurch Schäden oder Fehlfunktionen am Baugruppenträger 2 oder an der Baugruppe 1 durch irrtümlicherweise falschen Anschluß vermieden werden. Am Boden der Ausnehmung 42 ist ein Federelement 43 vorgesehen, durch welches der Anschluß der codierten Baugruppe 1 verbessert wird; denn das Codierelement 41 ist zum Ausgleich unvermeidbarer Toleranzen beweglich in der Ausnehmung 42 gelagert, wobei das Federelement 43 das Codierelement 41 in eine definierte Position drückt.

FIG 3 zeigt alternativ zu der in FIG 1 dargestellten Ausführungsform einen Moduleinbauplatz 15 des Kunststoffträgers 3, bei dem am Rand des Absatzes 16 im Bereich der Masseschienen 14 Durchbrüche als Schlitzpaare 25 vorhanden sind. In jedem Schlitzpaar 25 steckt ein Metallzungenpaar 27 (FIG 5). Das Metallzungenpaar 27 liegt mit seinem die beiden Zungen verbindenden Steg auf der jeweiligen Masseschiene 14 direkt kontaktierend auf. Außerdem besitzt der Moduleinbauplatz 15 anstelle des Federteils 8 bei der Ausführungsform nach FIG 1 einen Vorsprung in Form einer abgerundeten Nase 32, die in bestimmten Abständen c, d zu den Federleisten 5 liegt. Das sichere schadlose Aufeinandertreffen von Steck- 5 und Gegensteckanschlüssen 7 (siehe FIG 6) bei dieser Ausführungsform setzt allerdings verhältnismäßig kleine Fertigungstoleranzen oder unempfindlicher ausgebildete Steck- 5 und Gegensteckanschlüsse 7 voraus.

FIG 4 zeigt einen Teil der Baugruppe 1, die der Ausführungsform nach FIG 1 zugeordnet ist. Die Messerleisten 7 sind hier an einer zur Baugruppe 1 gehörenden Leiterplatte 11 befestigt, die Löcher 17 aufweist, in welche Zapfen 18 des Kunststoffteils 12 eingreifen. Das Kunststoffteil 12 ist zur Anschlußseite hin als Schürze ausgebildet, durch die das Gehäuse der Messerleisten 7 mechanisch geschützt ist. An der einen Schmalseite der Baugruppe 1 ist ein zum Federteil 8 des Kunststoffträgers 3 passender Steg 13 als Abstützteil vorgesehen, über das die Baugruppe 1 beim Aufschwenken auf den Baugruppenträger 2 positioniert wird. Hierdurch wird die aufgabengemäß angestrebte Positionierung der Messerleisten 7 zu den Federleisten 5 gewährleistet, indem den Abständen a, b zwischen dem Vorsprung 8 und den Federleisten 5 nach FIG 1 entsprechende Abstände e, f auch zwischen dem Steg 13 und den Messerleisten 7 eingehalten werden. Die Abstände sind untereinander so gewählt, daß beim Herabschwenken der Baugruppe der obere Rand der Einfassung der Messerleisten 7 jedenfalls etwas unterhalb des oberen Randes des gegenüberliegenden Gehäuses der Federleisten 5 aufliegt. Da letzter Gehäuserand üblicherweise angeschrägt ist, gleitet die Baugruppe 1 mit der Einfassung der Messerleisten 7 automatisch auf das Gehäuse der Federleisten 5, wodurch die Messer und die Federn miteinander kontaktieren. Wie bereits oben angedeutet, eignet sich eine solche Bauweise mit einem ausgleichenden Federteil 8, wenn mit größeren Abweichungen zwischen Soll- und Ist-Maßen zu rechnen ist. An den Schmalseiten der Baugruppe 1 befindet sich oberhalb der oberen Messerleiste 7 und unterhalb der unteren Messerleiste 7 jeweils ein Metallbügel 33, welcher beim Anschluß der Baugruppe 1 an dem Moduleinbauplatz 15 mit dem aus zugehörigem Durchbruch 25 hervorragenden Kontaktteil 26 der Masseschiene 14 kontaktiert.

FIG 6 zeigt die Ausführung der Baugruppe 1 für Bauformen mit vergleichsweise geringen Abmessungen und mit demzufolge erreichbaren kleinen Fertigungstoleranzen. Sie weist an ihrer auf den Baugruppenträger 2 aufzuschwenkenden Seite ein Kunststoffteil 12 auf, das allerdings von dem der Baugruppe 1 nach FIG 4 abweicht.

Zwischen der abgerundeten Nase 32 nach FIG 3 und den Federleisten 5 bestehen die Abstände c, d. Das Kunststoffteil 12 der Baugruppe 1 nach FIG 6 ist an der einen Schmalseite mit einer zur abgerundeten Nase 32 des Moduleinbauplatzes 15 passenden Vertiefung 23 versehen. Letztere weist die Abstände c, d zu den Messerleisten 7 auf, wodurch das maßgerechte Zusammenfügen der Messer und Federn von Federleisten 5 und Messerleisten 7 sichergestellt ist. Weichen jedoch die Abstände c, d der abgerundeten Nase 32 zu den Federleisten 5 von den Sollwerten ab, so sollte die zur Abstützung dienende entsprechende Vertiefung 23 im Kunststoffteil 12 der Baugruppe 1 soweit von den Messerleisten 7 entfernt liegen, daß wie zuvor für die Ausführung mit dem Federteil 8 beim Herabschwenken der Baugruppe 1 der obere Rand der Einfassung der Messerleisten 7 jedenfalls etwas unterhalb des oberen Randes des gegenüberliegenden Gehäuses der Federleisten 5 aufliegt. Das darauf erforderliche Anheben der Baugruppe 1 zum Zusammenfügen von Messerleisten 7 und Federleisten 5 kann durch ausreichenden Spielraum der Vertiefung 23 nach unten gewährleistet werden.

Der Anschluß der hier nicht dargestellten Leiterplatte in der Baugruppe 1 nach FIG 6 an die Masseschiene 14 wird über U-förmige Federn 34 (FIG 5) mit einem Masseanschlußmittel 31 bewerkstelligt, die zu den beiden äußeren Schmalseiten der Messerleisten 7 angebracht sind und die im eingeschwenkten Zustand der Baugruppe 1 auf den Baugruppenträger 2 die Metallzungenpaare 27 nach FIG 3 zweiseitig kontaktierend umgreifen. Dabei kann durch einen kurzen Abstand zwischen dem einen Metallzungenpaar 27 und dem Drehpunkt der Einschwenkhalterung 22 erreicht werden, daß zunächst eine Kontaktierung der Baugruppe 1 mit der Masseschiene 14 auftritt, bevor die weiteren Kontakte zwischen Messer- 7 und Federleisten 5 verbunden werden, was für zuvor beschriebene Ausführungsform der Baugruppe 1 nach FIG 4 ebenfalls zutrifft. Dies würde eine den Schutz der Baugruppen verbessernde Maßnahme darstellen.

Die zuvor beschriebene Positionierung mittels Vorsprüngen und dazu angepaßten Vertiefungen läßt sich aber auch dadurch erreichen, daß deren Lage miteinander vertauscht wird.

Alternativ zu den Federleisten 5 in Verbindung mit den Öffnungen 6 am Kunststoffträger 3 ließen sich aber auch einzelne Federn verwenden, welche in hierfür entsprechend ausgebildete Löcher im Kunststoffträger 3 eingesetzt werden, so daß dadurch die Federleistengehäuse 5 ersetzt werden.

FIG 7 zeigt eine Leiterplatte 11 einer Baugruppe 1, um deren Umfang zur Schirmung gegenüber elektrischen Feldern ein Metallblech 36 gelegt ist. Das Metallblech 36 besitzt an den beispielsweise überlappend oder aneinanderstoßend zusammengebrachten Enden im Bereich der Gegensteckanschlüsse 7 zur Aufnahme derselben einen angepaßten Ausschnitt 37. Das Metallblech 36 ist mindestens mit einer der beiden U-förmigen Federn 34 nach FIG 6 oder den Metallbügeln 33 der Baugruppe 1 nach FIG 4 elektrisch verbunden.

## Patentansprüche

1. Elektrische Anlage, zusammengesetzt aus einzelnen Baugruppen (1) und mit einem Baugruppenträger (2), der eine Busleiterplatte (4) aufweist, an der Steckanschlüsse (5) befestigt sind, die mit Gegensteckanschlüssen (7) der Baugruppen (1) durch Aufschwenken elektrisch in Verbindung bringbar und worauf die Baugruppen (1) mechanisch am Baugruppenträger (2) gehalten sind,
**dadurch gekennzeichnet,** daß
1. zum Baugruppenträger (2) ein Kunststoffträger (3) gehört,
2. der Kunststoffträger (3) mindestens eine zur Aufnahme der Steckanschlüsse (5) dienende Öffnung (6) aufweist,
3. am Kunststoffträger (3) in definiertem Abstand zur Öffnung (6) mindestens ein erster Vorsprung (8, 32) vorgesehen ist,
4. die Busleiterplatte (4) in definiertem Abstand zu den Steckanschlüssen (5) mindestens zwei Positionieröffnungen (9) aufweist,
5. an der den Baugruppen (1) abgewandten Seite des Kunststoffträgers (3) mindestens zwei den Positionieröffnungen (9) in Lage und Form angepaßte zweite Vorsprünge (10) vorgesehen sind,
6. für die zweiten Vorsprünge (10) und Positionieröffnungen (9) eine solche Lage vorgesehen ist, daß in deren zusammengefügtem Zustand die Steckanschlüsse (5) in definiertem Abstand zum ersten Vorsprung (8) liegend in die Öffnungen (6) hineinragen und von der den Baugruppen (1) zugewandten Seite des Kunststoffträgers (3) her mit den Gegensteckanschlüssen (7) kontaktierbar sind, wozu die Baugruppen (1) über ein Abstützteil (13, 23) an dem ersten Vorsprung (8, 32) abstützbar sind, das in einem Abstand zu den Gegensteckanschlüssen (7) vorgesehen ist, der auf den Abstand zwischen dem ersten Vorsprung (8, 32) und den Steckanschlüssen (5) am Baugruppenträger (2) abgestimmt ist.

2. Elektrische Anlage nach Anspruch 1, **dadurch gekennzeichnet,** daß auf der Seite der Gegensteckanschlüsse (7) die Baugruppen (1) ein Kunststoffteil (12) mit dem Abstützteil (13) besitzen und die Gegensteckanschlüsse (7) an einer Leiterplatte (11) befestigt sind, die erste Löcher (17) aufweist, in welche Zapfen (18) des Kunststoffteils (12) eingreifen.

3. Elektrische Anlage nach Anspruch 1 oder 2, **dadurch gekennzeichnet,** daß der erste Vorsprung ein Federteil (8) ist.

4. Elektrische Anlage nach Anspruch 3, **dadurch gekennzeichnet,** daß das Federteil (8) in einem solchen Abstand von den Steckanschlüssen (5) angeordnet ist, daß die Baugruppe (1) beim Aufschwenken über ihr Abstützteil (13) soweit von dem Federteil (8) hinabgedrückt wird, daß die Oberkante des Gehäuses der Gegensteckanschlüsse (7) unterhalb der Oberkante des Gehäuses der Steckanschlüsse (5) zu liegen kommt.

5. Elektrische Anlage nach einem der vorhergehenden Ansprüche, **dadurch gekennzeichnet,** daß die Steckanschlüsse als Federleisten (5) und die Gegensteckanschlüsse als Messerleisten (7) ausgeführt sind.

6. Elektrische Anlage nach einem der vorhergehenden Ansprüche, **dadurch gekennzeichnet,** daß der Kunststoffträger (3) eine modulare Aufteilung in mehrere Moduleinbauplätze (15) besitzt, wobei jedem Moduleinbauplatz (15) mindestens eine Öffnung (6) zugeordnet ist.

7. Elektrische Anlage nach Anspruch 6, **gekennzeichnet dadurch,** daß jeder Moduleinbauplatz (15) an seinem Rand einen ersten Absatz (16) mit einer zur Baugruppe (1) vorgesehenen Formpassung aufweist, die zumindest stellenweise ein Anliegen der Baugruppe (1) an dem ersten Absatz (16) beim Einschwenken und im eingeschwenkten Zustand der Baugruppe (1) bewirkt.

8. Elektrische Anlage nach Anspruch 7, **dadurch gekennzeichnet,** daß Baugruppen (1) mit mehrfacher Breite eines Moduleinbauplatzes (15) vorgesehen sind, die an den ersten Absätzen (16) mehrerer Moduleinbauplätze (15) stellenweise anliegen.

9. Elektrische Anlage nach einem der vorhergehenden Ansprüche, **dadurch gekennzeichnet,** daß das Kunststoffteil (12) der Baugruppen (1) mindestens teilweise um die Gegensteckanschlüsse (7) herum als vorstehende Schürze ausgebildet ist.

10. Elektrische Anlage nach einem der vorhergehenden Ansprüche, **dadurch gekennzeichnet,** daß der Baugruppenträger (2) mehr als eine Busleiterplatte (4) aufweist.

11. Elektrische Anlage nach einem der vorhergehenden Ansprüche, **dadurch gekennzeichnet,** daß eine zur Baugruppenbefestigung dienende Einschwenkhalterung (22) am Kunststoffträger (3) vorgesehen ist.

12. Elektrische Anlage nach einem der vorangehenden Ansprüche, **dadurch gekennzeichnet,** daß zwischen dem Kunststoffträger (3) und dem Baugruppenträger (2) mindestens eine Masseschiene (14) vorgesehen ist, die über mindestens einen Durchbruch (25) in dem Kunststoffträger (3) des Moduleinbauplatzes (15) kontaktierbar ist.

13. Elektrische Anlage nach einem der vorhergehenden Ansprüche, **dadurch gekennzeichnet,** daß die Masseschiene (14) vorstehende, leitende Kontaktteile (26) besitzt, die durch die Durchbrüche (25) zur Anschlußseite des Baugruppenträgers (2) hin vorragen.

14. Elektrische Anlage nach Anspruch 13, **dadurch gekennzeichnet,** daß die Kontaktteile (26) umgebogene Teile der Masseschiene (14) sind.

15. Elektrische Anlage nach Anspruch 13, **dadurch gekennzeichnet,** daß die Kontaktteile (26) mit der Masseschiene (14) elektrisch leitend verbindbar sind.

16. Elektrische Anlage nach Anspruch 15, **dadurch gekennzeichnet,** daß die Kontaktteile (26) Metallzungenpaare (27) sind, die als Schenkel von U-förmigen Teilen ausgebildet sind.

17. Elektrische Anlage nach einem der vorhergehenden Ansprüche, **dadurch gekennzeichnet,** daß der Baugruppenträger (2) aus dem Kunststoffträger (3), einem parallel angeordneten Träger (21) und der zwischen diesem und dem Kunststoffträger (3) liegenden Busleiterplatte (4) zusammengesetzt ist und diese Bauteile Mittel (9, 10) zur Positionierung beim Aufeinanderschichten besitzen.

18. Elektrische Anlage nach einem der vorhergehenden Ansprüche, **dadurch gekennzeichnet,** daß durch den Kunststoffträger (3), den Baugruppenträger (2) und durch die Masseschiene (14) in einer Flucht ein zweites Loch (28) hindurchführt und in dieses zweite Loch (28) eine metallische Gewindebuchse (29) vom Kunststoffträger (3) her steckbar ist, die ein durchgehendes Gewinde (19) aufweist und die über dieses Gewinde (19 die Masseschiene (14) und die Kontaktteile (26) mittels einer Schraube (39) von der Rückseite des Baugruppenträgers (2) her gegen den Träger (21) drückt.

19. Elektrische Anlage nach Anspruch 18, **dadurch gekennzeichnet,** daß die Gewindebuchse (29) einen sechskantigen Kopf aufweist und der Kunststoffträger (3) mit einer ersten Ausnehmung (38) in Form des sechskantigen Kopfes am Eingang des zweiten Loches (28) versehen ist.

20. Elektrische Anlage nach einem der vorhergehenden Ansprüche, **dadurch gekennzeichnet,** daß der Kunststoffträger (3) einen Hohlraum (20) zur Busleiterplatte (4) hin aufweist.

21. Elektrische Anlage nach einem der vorhergehenden Ansprüche, **dadurch gekennzeichnet,** daß wenigstens ein Moduleinbauplatz (15) des Baugruppenträgers (2) ein Codierelement (41) aufweist.

22. Elektrische Anlage nach Anspruch 21, **dadurch gekennzeichnet,** daß zur Aufnahme des Codierelements (41) eine zweite Ausnehmung (42) am Kunststoffträger (3) vorgesehen ist und am Boden der zweiten Ausnehmung (42) ein Federelement (43) vorhanden ist.

## Claims

1. Electrical installation, composed of individual modules (1) and having a mounting rack (2) which has a bus printed circuit board (4), to which plug-in connections (5) are fastened, which can be brought into electrical connection with counter plug-in connections (7) of the modules (1) by pivoting-on and whereupon the modules (1) are mechanically held on the mounting rack (2), characterized in that
1. a plastics support (3) belongs to the mounting rack (2),
2. the plastics support (3) has at least one opening (6) serving to accommodate the plug-in connections (5),
3. at least a first projection (8, 32) is provided on the plastics support (3) with defined clearance from the opening (6),
4. the bus printed circuit board (4) has at least two positioning openings (9) with defined clearance from the plug-in connections (5),
5. on the side of the plastics support (3) away from the modules (1) at least two second projections (10) adapted to the positioning openings (9) in position and form are provided,
6. for the second projections (10) and positioning openings (9) such a position is provided that in their joined state the plug-in connections (5) lying with defined clearance from the first projection (8) project into the openings (6) and from the side of the plastics support (3) facing the modules (1) can be contacted with the counter plug-in connections (7), for which purpose the modules (1) can be supported by way of a supporting part (13, 23) on the first projection (8, 32), which is provided with a spacing from the counter plug-in connections (7), which is coordinated with the spacing between the first projection (8, 32) and the plug-in connections (5) on the mounting rack (2).

2. Electrical installation according to claim 1, characterized in that on the side of the counter plug-in connections (7) the modules (1) have a plastics part (12) with the supporting part (13) and the counter plug-in connections (7) are fastened to a printed circuit board (11) which has first holes (17) into which lugs (18) of the plastics part (12) engage.

3. Electrical installation according to claim 1 or 2, characterized in that the first projection is a spring part (8).

4. Electrical installation according to claim 3, characterized in that the spring part (8) is arranged with such clearance from the plug-in connections (5) that the module (1) with pivoting-on by way of its supporting part (13) is pressed so far away from the spring part (8) that the upper edge of the housing of the counter plug-in connections (7) comes to lie underneath the upper edge of the housing of the plug-in connections (5).

5. Electrical installation according to one of the preceding claims, characterized in that the plug-in connections are designed as socket connectors (5) and the counter plug-in connections are designed as plug connectors (7).

6. Electrical installation according to one of the preceding claims, characterized in that the plastics support (3) has a modular division into several module slots (15), with at least one opening (6) being associated with each module slot (15).

7. Electrical installation according to claim 6, characterized in that each module slot (15) at its edge has a first step (16) with a form-fit provided for the module (1), which effects at least in places an abutment of the module (1) on the first step (16) with the pivoting and in the pivoted state of the module (1).

8. Electrical installation according to claim 7, characterized in that modules (1) with multiple width of a module slot (15) are provided which abut the first steps (16) of several module slots (15) in places.

9. Electrical installation according to one of the preceding claims, characterized in that the plastics part (12) of the modules (1) is constructed at least in part about the counter plug-in connections (7) as a projecting apron.

10. Electrical installation according to one of the preceding claims, characterized in that the mounting rack (2) has more than one bus printed circuit board (4).

11. Electrical installation according to one of the preceding claims, characterized in that a pivot holder (22) serving the module fastening is provided on the plastics support (3).

12. Electrical installation according to one of the preceding claims, characterized in that between the plastics support (3) and the mounting rack (2) at least one earthing bar (14) is provided, which can be contacted by way of at least one opening (25) in the plastics support (3) of the module slot (15).

13. Electrical installation according to one of the preceding claims, characterized in that the earthing bar (14) has projecting, conducting contact parts (26) which project through the openings (25) towards the terminal side of the mounting rack (2).

14. Electrical installation according to claim 13, characterized in that the contact parts (26) are bent parts of the earthing bar (14).

15. Electrical installation according to claim 13, characterized in that the contact parts (26) can be connected in an electroconductive manner to the earthing bar (14).

16. Electrical installation according to claim 15, characterized in that the contact parts (26) are pairs of metal tongues (27) which are constructed as limbs of U-shaped parts.

17. Electrical installation according to one of the preceding claims, characterized in that the mounting rack (2) is composed of the plastics support (3), a support (21) arranged in parallel and the bus printed circuit board (4) lying between it and the plastics support (3) and these component parts have means (9, 10) for the positioning during the layering on top of one another.

18. Electrical installation according to one of the preceding claims, characterized in that a second hole (28) passes through the plastics support (3), the mounting rack (2) and through the earthing bar (14) in a line and into this second hole (28) a metallic threaded bushing (29) from the plastics support (3) can be inserted, which threaded bushing has a continuous thread (19) and which by way of this thread (19) presses the earthing bar (14) and the contact parts (26) by means of a screw (39) from the rear side of the mounting rack (2) against the support (21).

19. Electrical installation according to claim 18, characterized in that the threaded bushing (29) has a hexagonal head and the plastics support (3) is provided with a first recess (38) in the form of the hexagonal head at the entrance of the second hole (28).

20. Electrical installation according to one of the preceding claims, characterized in that the plastics support (3) has a cavity (20) towards the bus printed circuit board (4).

21. Electrical installation according to one of the preceding claims, characterized in that at least one module slot (15) of the mounting rack (2) has a coding element (41).

22. Electrical installation according to claim 21, characterized in that to incorporate the coding element (41) a second recess (42) is provided on the plastics support (3) and on the base of the second recess (42) there is a spring element (43).

## Revendications

1. Installation électrique composée de divers modules (1) et ayant un porte-modules (2), qui comporte une plaque portant des conducteurs de bus (4), auxquels sont fixés des bornes à enfichage (5), qui peuvent être connectées électriquement, par basculement, aux bornes à enfichage antagoniste (7) des modules (1), les modules (1) étant alors maintenus mécaniquement sur le porte-modules (2), caractérisée par le fait que
1. un support (3) en matière plastique fait partie du porte-modules (2),
2. le support (3) en matière plastique comporte au moins une ouverture (6) servant à recevoir les bornes à enfichage (5),
3. au moins une partie saillante (8, 32) est prévue sur le support (3) en matière plastique, à une distance définie de l'ouverture (6),
4. la plaque à conducteurs de bus (4) comporte au moins deux ouvertures de mise en position (9), à une distance définie des bornes à enfichage (5),
5. au moins deux secondes parties saillantes (10), qui sont adaptées en position et forme aux ouvertures de mise en position (9), sont prévues sur la face du support (3) en matière plastique, qui est tournée à l'opposé des modules (1),
6. pour les secondes parties saillantes (10) et les ouvertures de mise en position (9) il est prévu une position telle qu'à l'état assemblé, les bornes à enfichage (5) pénètrent dans les ouvertures (6), à une distance définie de la première partie saillante (8), et un contact peut être établi avec ces bornes à enfichage à partir de la face du support (3) en matière plastique, tournée vers les modules (1), à l'aide des bornes à enfichage antagonistes (7), les modules (1) pouvant s'appuyer sur la première partie saillante (8, 32) par l'intermédiaire d'un élément d'appui (13, 23) qui est prévu à une distance des bornes à enfichage antagonistes (7), qui est réglée sur la distance comprise entre la première partie saillante (8, 32) et les bornes à enfichage (5) situées sur le porte-modules (2).

2. Installation électrique suivant la revendication 1, caractérisée par le fait que sur la face des bornes à enfichage antagonistes (7), les modules (1) possèdent une pièce (12) en matière plastique munie de la pièce d'appui (13) et que les bornes à enfichage antagonistes (7) sont fixées sur une plaquette à circuits imprimés (11), qui comportent des premiers trous (17), dans lesquels pénètrent des tétons (18) de la pièce (12) en matière plastique.

3. Installation électrique suivant la revendication 1 ou 2, caractérisée par le fait que la première partie saillante est une pièce (8) élastique.

4. Installation électrique suivant la revendication 3, caractérisée par le fait que la pièce (8) élastique est à une distance telle des bornes à enfichage (5) que le module (1) est repoussé par la pièce (8) élastique, lors du basculement par sa pièce (13) d'appui, au point que le bord supérieur du boîtier des bornes à enfichage antagonistes (7) vienne sous le bord supérieur du boîtier des bornes à enfichage (5).

5. Installation électrique suivant l'une des revendications précédentes, caractérisée par le fait que les bornes à enfichage sont réalisées sous la forme de barrettes à ressorts (5) et que les bornes à enfichage antagonistes sont réalisées sous la forme de barrettes à couteaux (7).

6. Installation électrique suivant l'une des revendications précédentes,caractérisée par le fait que le support (3) en matière plastique est subdivisé de façon modulaire en plusieurs postes (15) de montage de modules, au moins une ouverture (6) étant associée à chaque poste (15) de montage de modules.

7. Installation électrique suivant la revendication 6, caractérisée par le fait que chaque poste (15) de montage de modules a, sur son bord, une première partie étagée (16) de forme adaptée au module (1), qui permet d'obtenir, au moins par endroits, une application du module (1) sur la première partie étagée (16) lors de la fermeture par basculement et lorsque le module est rentré par basculement.

8. Installation électrique suivant la revendication 7, caractérisée par le fait qu'il est prévu des modules (1) d'une largeur représentant plusieurs fois celle d'un poste (15) de montage de modules, qui s'appliquent, par endroits, sur les premières parties étagées (16) de plusieurs postes (15) de montage de modules.

9. Installation électrique suivant l'une des revendications précédentes, caractérisée par le fait que la pièce (12) en matière plastique des modules (1) a au moins partiellement autour des bornes à enfichage antagonistes (7), la forme d'une jupe saillante.

10. Installation électrique suivant l'une des revendications précédentes, caractérisée par le fait que le porte-modules (2) comporte plus d'une plaque de conducteurs de bus (4).

11. Installation électrique suivant l'une des revendications précédentes, caractérisée par le fait que sur le support (3) en matière plastique est prévu une pièce de fixation (22) basuclante qui sert à la fixation des modules.

12. Installation électrique suivant l'une des revendications précédentes, caractérisé par le fait qu'entre le support (3) en matière plastique et le porte-modules (2) est prévu au moins un rail de masse (14), par lequel un contact peut être établi par l'intermédiaire d'au moins un passage (25) ménagé dans le support (3) en matière plastique du poste (15) de montage de modules.

13. Installation électrique suivant l'une des revendications précédentes, caractérisée par le fait que le rail de masse (14) possède des pièces de contact (26) saillantes, conductrices, qui font saillie par les passages (25) en direction de la face de raccordement du porte-modules (2).

14. Installation électrique suivant la revendication 13, caractérisée par le fait que les pièces de contact (26) sont des parties coudées du rail de masse (14).

15. Installation électrique suivant la revendication 13, caractérisée par le fait que les pièces de contact (26) peuvent être connectées d'une manière électriquement conductrice au rail de masse (14).

16. Installation électrique suivant la revendication 15, caractérisée par le fait que les pièces de contact (26) sont des couples de languettes (27) métalliques, qui ont la forme de branches de pièces en forme de U.

17. Installation électrique suivant l'une des revendications précédentes, caractérisée par le fait que le porte-modules (2) est composé du support (3) en matière plastique, d'un support parallèle (21) et de la plaque de conducteurs de bus (4) entre ce support et le support (3) en matière plastique, et que ces composants possèdent des moyens de mise en position (9, 10), lors de la superposition des couches.

18. Installation électrique suivant l'une des revendications précédentes, caractérisée par le fait qu'un second trou (28) traverse, d'une manière alignée, le support (3) en matière plastique, le porte-modules (2) et le rail de masse (14) et que dans ce second trou (28) peut être enfilée, à partir du support (3) en matière plastique, une douille taraudée (29) métallique, qui a un taraudage continu (19) et qui repousse, par l'intermédiaire de ce taraudage (19), le rail de masse (14) et les pièces de contact (26) sur le support (21), au moyen d'une vis (39), à partir de la face arrière du porte-modules (2).

19. Installation électrique suivant la revendication 18, caractérisée par le fait que la douille taraudée (29) a une tête hexagonale et que le support (3) en matière plastique comporte un premier évidement (38) ayant la forme de la tête hexagonale, à l'entrée du second trou (28).

20. Installation électrique suivant l'une des revendications précédentes, caractérisée par le fait que le support (3) en matière plastique a une cavité (20) en direction de la plaque à conducteurs de bus (4).

21. Installation électrique suivant l'une des revendications précédentes, caractérisée par le fait qu'au moins un poste (15) de montage d'un module du porte-modules (2) a un élément de codage (41).

22. Installation électrique suivant la revendication 21, caractérisée par le fait qu'un second évidement (42) est prévu dans le support (3) en matière plastique pour recevoir l'élément de codage (41) et qu'un élément élastique (43) est présent au fond du second évidement (42).
